# EUROPÄISCHE PATENTSCHRIFT

(11) **EP 1 166 350 B1**
(45) Veröffentlichungstag und Bekanntmachung des Hinweises auf die Patenterteilung: **10.01.2007**
(21) Anmeldenummer: 00918692.5
(22) Anmeldetag: 10.03.2000
(51) Int. Cl.: H01L 21/8242, H01L 27/108

(54) **VERFAHREN ZUR HERSTELLUNG EINER DRAM-STRUKTUR MIT VERGRABENEN BITLEITUNGEN ODER GRABENKONDENSATOREN**
METHOD FOR PRODUCING A DRAM STRUCTURE WITH BURIED BIT LINES OR TRENCH CAPACITORS
CIRCUIT INTEGRE COMPRENANT UNE STRUCTURE CONDUCTRICE ENTERREE DANS UN SUBSTRAT QUI EST RELIEE ELECTRIQUEMENT A UNE REGION DU SUBSTRAT, ET SON PROCEDE DE PRODUCTION

(30) Priorität: 12.03.1999 DE 19911149
(43) Veröffentlichungstag der Anmeldung: 02.01.2002
(73) Patentinhaber: Infineon Technologies AG, 81669 München (DE)
(72) Erfinder: WILLER, Josef, D-85521 Riemerling (DE); CAPPELLANI, Annalisa, D-01097 Dresden (DE); SELL, Bernhard, D-01099 Dresden (DE)
(74) Vertreter: Kottmann, Heinz Dieter
(86) Internationale Anmeldenummer: PCT/DE2000/000757
(87) Internationale Veröffentlichungsnummer: WO 2000/055905

(56) Entgegenhaltungen:
- EP-A- 0 462 576
- EP-A- 0 621 632
- EP-A- 0 987 765
- US-A- 5 410 169
- US-A- 5 633 200
- US-A- 5 670 805
- PATENT ABSTRACTS OF JAPAN vol. 015, no. 125 (E-1050), 27. März 1991 (1991-03-27) & JP 03 011735 A (SONY CORP), 21. Januar 1991 (1991-01-21)
- PATENT ABSTRACTS OF JAPAN vol. 013, no. 086 (E-720), 28. Februar 1989 (1989-02-28) & JP 63 263758 A (HITACHI LTD), 31. Oktober 1988 (1988-10-31)

## Beschreibung

Die Erfindung betrifft eine integrierte Schaltungsanordnung, die eine in einem Substrat vergrabene leitende Struktur umfaßt, die mit einem Gebiet des Substrats elektrisch verbunden ist, sowie ein Verfahren zu deren Herstellung.

EP 0 852 396 A2 beschreibt eine integrierte Schaltungsanordnung, d.h. eine Schaltungsanordnung, die in einem Substrat angeordnet ist, die als DRAM-Zellenanordnung ausgestaltet ist. Eine Speicherzelle der DRAM-Zellenanordnung umfaßt einen Speicherkondensator und einen Transistor. Ein Speicherknoten des Speicherkondensators ist im Substrat vergraben und grenzt an ein Source/Drain-Gebiet des Transistors an, das als dotiertes Gebiet des Substrats ausgestaltet ist. Für jede Speicherzelle wird im Substrat eine Vertiefung erzeugt. Ein Boden und Flanken eines unteren Teils der Vertiefung werden mit einem Kondensatordielektrikum versehen. Der untere Teil der Vertiefung wird mit dotiertem Polysilizium gefüllt, so daß der Speicherknoten erzeugt wird. Anschließend wird weiteres dotiertes Polysilizium in die Vertiefung eingebracht, das an eine Flanke der Vertiefung direkt an das Substrat angrenzt. Durch einen Temperschritt diffundiert Dotierstoff des Polysiliziums in das Substrat und bildet dort das Source/Drain-Gebiet des Transistors. Nach Erzeugung eines Gatedielektrikums wird über dem Speicherknoten in der Vertiefung eine Gateelektrode erzeugt. Ein weiteres Source/Drain-Gebiet des Transistors wird oberhalb des Source/Drain-Gebiets erzeugt, so daß der Transistor ein vertikaler Transistor ist, bei dem ein Kanalstrom bezüglich einer Oberfläche des Substrats senkrecht verläuft.

US 5 497 017 beschreibt eine integrierte Schaltungsanordnung, die eine DRAM-Zellenanordnung ist. Eine Speicherzelle der DRAM-Zellenanordnung umfaßt einen Speicherkondensator und einen Transistor. Eine Bitleitung ist in einem Substrat vergraben und mit einem Source/Drain-Gebiet des Transistors elektrisch verbunden. Zur Erzeugung der Bitleitung wird im Substrat ein Graben erzeugt, dessen Flanken und Boden mit einer isolierenden Struktur versehen werden. Der Graben wird mit Wolfram gefüllt, so daß die Bitleitung erzeugt wird. Anschließend wird ein Teil des Substrats und der isolierenden Struktur an einem oberen Teil einer Flanke des Grabens entfernt, so daß die Bitleitung seitlich freigelegt wird. Das Source/Drain-Gebiet des Transistors wird anschließend durch selektive Epitaxie erzeugt. Durch weitere selektive Epitaxie wird ein über dem Source/Drain-Gebiet angeordnetes Kanalgebiet und ein über dem Kanalgebiet angeordnetes weiteres Source/Drain-Gebiet erzeugt. Der Transistor ist als vertikaler Transistor ausgestaltet.

In K. Nakajima "Formation mechanism of ultrathin WSiN barrier layer in a W/WN_{X}/Si system", Applied Surface Science 117/118 (1997), 312, wird eine Gateelektrode beschrieben, die eine hohe elektrische Leitfähigkeit aufweist. Ein unterer Teil der Gateelektrode, der an ein Gatedielektrikum angrenzt, besteht aus dotiertem Polysilizium. Ein oberer Teil der Gateelektrode besteht aus Wolfram. Zwischen dem oberen Teil und dem unteren Teil der Gateelektrode ist eine Diffusionsbarriere angeordnet, die Stickstoff enthält. Die Diffusionsbarriere besteht aus einer Schicht, die die Elemente Si, N und W enthält. Die Diffusionsbarriere verhindert, daß das Wolfram insbesondere bei höheren Temperaturen siliziert, was zu einer kleineren elektrischen Leitfähigkeit der Gateelektrode führen würde.
Zur Erzeugung der Diffusionsbarriere wird ein Wolfram-Target in einer Gasmischung aus Ar und N₂ gesputtert.

Der Erfindung liegt das Problem zugrunde, eine integrierte Schaltungsanordnung, die eine in einem Substrat vergrabene leitende Struktur umfaßt, die mit einem Gebiet des Substrats elektrisch verbunden ist, anzugeben, die mit kleinem Prozeßaufwand herstellbar ist und bei der zugleich die leitende Struktur eine hohe elektrische Leitfähigkeit aufweisen kann. Ferner soll ein Verfahren zur Herstellung einer solchen integrierten Schaltungsanordnung angegeben werden.

Das Problem wird gelöst durch eine integrierte Schaltungsanordnung, die eine in einem Substrat vergrabene leitende Struktur umfaßt, die mit einem Gebiet des Substrats elektrisch verbunden ist, bei der die leitende Struktur einen ersten Teil, einen zweiten Teil und eine Diffusionsbarriere umfaßt. Das Substrat weist eine Vertiefung auf. Ein Boden und Flanken eines unteren Teils der Vertiefung sind mit einer isolierenden Struktur versehen. Der erste Teil der leitenden Struktur, der eine erste elektrische Leitfähigkeit aufweist, ist im unteren Teil der Vertiefung angeordnet. Der zweite Teil der leitenden Struktur, der eine zweite elektrische Leitfähigkeit aufweist, die kleiner als die erste elektrische Leitfähigkeit ist, ist in einem höheren Teil der Vertiefung angeordnet und grenzt bei einem Teil mindestens einer der Flanken der Vertiefung an das Gebiet des Substrats an. Die Diffusionsbarriere ist zwischen dem ersten Teil und dem zweiten Teil der leitenden Struktur angeordnet.

Das Problem wird ferner gelöst durch ein Verfahren zur Herstellung einer integrierten Schaltungsanordnung, die eine in einem Substrat vergrabene leitende Struktur umfaßt, die mit einem Gebiet des Substrats elektrisch verbunden ist, bei dem zunächst im Substrat eine Vertiefung erzeugt wird. Ein Boden und Flanken eines unteren Teils der Vertiefung werden mit einer isolierenden Struktur versehen. Ein erster Teil der leitenden Struktur, der eine erste elektrische Leitfähigkeit aufweist, wird so erzeugt, daß er im unteren Teil der Vertiefung angeordnet ist. Anschließend wird ein Material auf den ersten Teil der leitenden Struktur aufgebracht. Ein zweiter Teil der leitenden Struktur, der eine zweite elektrische Leitfähigkeit aufweist, die kleiner als die erste elektrische Leitfähigkeit ist, wird auf dem Material so erzeugt, daß er in einem höheren Teil der Vertiefung angeordnet ist und bei einem Teil mindestens einer der Flanken der Vertiefung an das Gebiet des Substrats angrenzt. Zwischen dem ersten Teil und dem zweiten Teil der leitenden Struktur wird mit Hilfe des Materials eine Diffusionsbarriere erzeugt, die ebenfalls Teil der leitenden Struktur ist.

Die Diffusionsbarriere ermöglicht es, daß der erste Teil der leitenden Struktur aus einem Material bestehen kann, das leicht in ein Material, aus dem das Substrat besteht, diffundiert oder mit dem Material des Substrats reagiert. Besteht das Substrat beispielsweise aus Silizium, so kann der erste Teil der leitenden Struktur ein Metall enthalten, ohne daß sich bei Temperaturerhöhung aus dem Metall ein Metallsilizid, das eine niedrigere elektrische Leitfähigkeit aufweist, bildet.

Die Diffusionsbarriere kann aus isolierendem Material bestehen und eine Dicke aufweisen, die Tunneln von Elektronen ermöglicht. Das isolierende Material kann z.B. SiO₂ oder Siliziumnitrid sein.

Vorzugsweise besteht die Diffusionsbarriere im wesentlichen aus leitendem Material, damit ein Kontaktwiderstand zwischen Metall des ersten Teils und Silizium des zweiten Teils der leitenden Struktur besonders klein ist und somit im Endeffekt eine höhere elektrische Leitfähigkeit der leitenden Struktur erzielt wird.

Eine solche Diffusionsbarriere bewirkt darüber hinaus, daß eine dünne Oxidschicht, die unerwünschterweise auf dem Metall durch Kontakt mit Sauerstoff entstehen kann, durchbrochen wird.

Der erste Teil der leitenden Struktur ist für eine hohe elektrische Leitfähigkeit der leitenden Struktur verantwortlich. Der Prozeßaufwand zur Herstellung der integrierten Schaltungsanordnung kann aufgrund des zweiten Teils der leitenden Struktur klein sein, weil auch nach Erzeugung der leitenden Struktur Verfahrensschritte mit hohen Temperaturen ohne Verlust der hohen elektrischen Leitfähigkeit der leitenden Struktur möglich sind. So können z.B. Source/Drain-Gebiete oder Gatedielektrika von Transistoren durch Implantation und Tempern erzeugt werden. Auf aufwendige Epitaxie kann verzichtet werden.

Der zweite Teil der leitenden Struktur enthält vorzugsweise ein Material, das nicht leicht in das Material des Substrats diffundiert. Vorzugsweise enthält der zweite Teil der leitenden Struktur Polysilizium, wenn das Substrat Silizium enthält.

Die Diffusionsbarriere enthält zum Beispiel Stickstoff.

Wolfram ist als Material des ersten Teils der leitenden Struktur besonders geeignet, wenn das Substrat aus Silizium besteht, da der thermische Ausdehnungskoeffizient von Silizium und der thermische Ausdehnungskoeffizient von Wolfram sehr ähnlich sind, so daß, obwohl der erste Teil der leitenden Struktur im Substrat vergraben ist, mechanische Spannungen bei Temperaturveränderungen und daraus resultierende Defekte vermieden werden. Besteht der erste Teil der leitenden Struktur aus Wolfram, so enthält die Diffusionsbarriere Stickstoff, Wolfram und Silizium.

Es liegt im Rahmen der Erfindung, den ersten Teil der leitenden Struktur aus einem anderen Metall, zum Beispiel Molybdän, Titan, Niob, Ruthenium oder Tantal zu erzeugen.

Das Gebiet des Substrats, an das der zweite Teil der leitenden Struktur angrenzt, kann dotiert sein. Beispielsweise ist das Gebiet des Substrats ein Source/Drain-Gebiet eines Transistors. Zur Vereinfachung des Herstellungsverfahrens ist es vorteilhaft, wenn in diesem Fall das Polysilizium des zweiten Teils der leitenden Struktur vom selben Leitfähigkeitstyp wie das Gebiet des Substrats dotiert ist. In diesem Fall kann das Gebiet des Substrats auf einfache Weise erzeugt werden, indem mit Hilfe eines Temperschritts Dotierstoff des Polysiliziums des zweiten Teils der leitenden Struktur in das Substrat diffundiert und dort das Gebiet des Substrats bildet.

Der erste Teil der leitenden Struktur kann durch Abscheiden von Material erzeugt werden. Die Vertiefung wird mit dem Material gefüllt. Anschließend wird das Material bis zur gewünschten Tiefe rückgeätzt. Das Material des ersten Teils der leitenden Struktur wird vorzugsweise durch ein CVD-Verfahren abgeschieden, so daß der erste Teil der leitenden Struktur horizontal verlaufende Fasern, d.h. längliche Kristallite, aufweist, die an Flanken der Vertiefung angeordnet sind.

Es kann eine Keimschicht verwendet werden, die die Flanken und den Boden der Vertiefung bedeckt.

Ein solches Verfahren ist besonders schnell, wenn die Vertiefung mehr als doppelt so tief wie breit ist, da die Vertiefung unabhängig von der seiner Tiefe gefüllt wird, wenn die Dicke des abgeschiedenen Materials der halben Breite der Vertiefung entspricht.

Die Keimschicht kann zum Beispiel durch Abscheiden einer geringen Menge von Material, aus dem die Keimschicht besteht, erzeugt werden. Auf die Keimschicht kann aber auch verzichtet werden.

Der erste Teil der leitenden Struktur kann alternativ durch selektives Wachstum auf einer Keimschicht erzeugt werden. Dazu wird nach Erzeugung der isolierenden Struktur auf einem Teil der isolierenden Struktur, der am Boden der Vertiefung angeordnet ist, eine Keimschicht erzeugt. Das selektive Wachstum ist von unten nach oben gerichtet, so daß der erste Teil der leitenden Struktur Längsfasern aufweist, die sich von unten nach oben erstrecken. Im Gegensatz zum CVD-Verfahren besteht keine Gefahr, daß sich in der Mitte der Vertiefung eine Fuge bildet, aufgrund der bei Rückätzen_der Boden der Vertiefung angegriffen werden kann. Darüber hinaus ist ein Rückätzen von Material nicht erforderlich. Die Höhe einer oberen Oberfläche des ersten Teils der leitenden Struktur wird durch Aufwachsen und nicht durch die Differenz zweiter Ätztiefen, nämlich der Tiefe beim Rückätzen und der Tiefe der Vertiefung, bestimmt, so daß besagte Höhe genauer eingestellt werden kann.

Die Keimschicht kann zum Beispiel durch Implantation oder durch Sputtern, vorzugsweise stark gerichtetem Sputtern (z.B. lonized Metal PVD), erzeugt werden. Beim Sputtern wird Material auch an Flanken der Vertiefung sowie außerhalb der Vertiefung abgeschieden. Beim stark gerichteten Sputtern, weisen die gesputterten Teilchen zu einem sehr großen Teil denselben Einfallswinkel auf. Material, das außerhalb der Vertiefung aufgebracht wird, kann zum Beispiel durch chemisch mechanisches Polieren oder durch Ätzen mit Hilfe einer Lackmaske, die die Vertiefung füllt, entfernt werden. Material, das an den Flanken der Vertiefung aufgebracht wird, kann z.B. durch isotropes Ätzen entfernt werden. Besteht der erste Teil der leitenden Struktur aus Wolfram oder Ruthenium, so besteht die Keimschicht vorzugsweise aus demselben entsprechenden Metall oder aus Silizium.

Die Keimschicht ist vorzugsweise zwischen 1nm und 5nm dick. Besteht die Keimschicht aus Silizium, so könnte eine dickere Keimschicht zur Bildung einer nicht vernachlässigbaren Menge an Metallsilizid führen, was eine Erhöhung des elektrischen Widerstands der leitenden Struktur bewirken würde.

Der erste Teil der leitenden Struktur kann auch durch Sputtern erzeugt werden. In diesem Fall ist keine Keimschicht erforderlich. Besonders vorteilhaft ist ein stark gerichtetes Sputtern, da an Flanken der Vertiefung besonders wenig Material abgeschieden wird, so daß ein kurzer isotroper Atzschritt genügt, um das Material an den Flanken der Vertiefung oberhalb des ersten Teils der leitenden Struktur zu entfernen.

Die Diffusionsbarriere kann erzeugt werden, indem nach Erzeugung des ersten Teils der leitenden Struktur Stickstoff implantiert wird. Nach Erzeugung des zweiten Teils der leitenden Struktur wird aus dem Stickstoff und angrenzenden Teilen der leitenden Struktur die Diffusionsbarriere mit Hilfe eines Temperschritts erzeugt.

Alternativ kann nach Erzeugung des ersten Teils der leitenden Struktur ein Metallnitrid abgeschieden werden, das dasselbe Metall wie das Metall des ersten Teils der leitenden Struktur enthält. Durch einen Temperschritt entsteht aus dem Metallnitrid und einem Teil des zweiten Teils der leitenden Struktur die Diffusionsbarriere.

Die Diffusionsbarriere kann auch teilweise aus dem ersten Teil der leitenden Struktur gebildet werden. Dazu wird der erste Teil der leitenden Struktur aus Metallnitrid erzeugt. Mit Hilfe eines Temperschritts diffundiert Stickstoff des Metallnitrids an eine obere Fläche des ersten Teils der leitenden Struktur. Eine mit Stickstoff angereicherte Schicht des ersten Teils der leitenden Struktur ist Teil der Diffusionsbarriere.

Die integrierte Schaltungsanordnung kann zum Beispiel eine DRAM-Zellenanordnung mit Speicherzellen sein, die jeweils mindestens einen Transistor aufweisen. Das Gebiet des Substrats, an das der zweite Teil der leitenden Struktur angrenzt, ist beispielsweise ein Source/Drain-Gebiet des Transistors.

Die leitende Struktur kann als Bitleitung wirken. In diesem Fall ist die isolierende Struktur so dick, daß eine nennenswerte Kapazität zwischen der Bitleitung und dem Substrat vermieden wird.

Alternativ kann die leitende Struktur als Speicherknoten eines Kondensators wirken, der ebenfalls Teil der Speicherzelle ist. In diesem Fall ist die isolierende Struktur so ausgestaltet, daß sie als Kondensatordielektrikum des Kondensators wirken kann.

Zur Erhöhung der Packungsdichte kann der Transistor als vertikaler Transistor ausgestaltet sein. Ein weiteres Source/Drain-Gebiet des Transistors ist oberhalb des Source/Drain-Gebiets angeordnet und grenzt an die Flanke der Vertiefung an, bei der der zweite Teil der leitenden Struktur an das Source/Drain-Gebiet angrenzt. Zwischen dem weiteren Source/Drain-Gebiet und dem Source/Drain-Gebiet ist ein Kanalgebiet des Transistors angeordnet. Eine Isolation bedeckt die leitende Struktur und oberhalb der leitenden Struktur angeordnete Teile der Flanken der Vertiefung. Eine Gateelektrode des Transistors ist in der Vertiefung angeordnet und durch die Isolation von der leitenden Struktur und vom Substrat getrennt. Im Bereich des Kanalgebiets wirkt die Isolation als Gatedielektrikum.

Mindestens ein Teil der Isolation kann durch thermische Oxidation erzeugt werden.

Der Transistor kann alternativ als planarer Transistor ausgestaltet sein.

Zur Erhöhung der Packungsdichte ist es vorteilhaft, wenn der zweite Teil der leitenden Struktur an nur eine Flanke der Vertiefung an das Gebiet des Substrats angrenzt. In diesem Fall können Vertiefungen verschiedener Speicherzellen in geringer Entfernung voneinander angeordnet werden, ohne daß es zu Leckströmen zwischen zueinander benachbarten leitenden Strukturen kommt.

Im folgenden werden Ausführungsbeispiele der Erfindung anhand der Figuren näher erläutert.
- Figur 1: zeigt einen Querschnitt durch ein erstes Substrat, nachdem eine erste Oxidschicht, eine Nitridschicht, eine zweite Oxidschicht, eine Vertiefung, eine isolierende Struktur und eine Keimschicht erzeugt wurden.
- Figur 2: zeigt den Querschnitt aus Figur 1, nachdem ein erster Teil einer leitenden Struktur und eine Schicht, die Stickstoff enthält, erzeugt wurden und ein Teil der isolierenden Struktur und die zweite Oxidschicht entfernt wurden.
- Figur 3: zeigt den Querschnitt aus Figur 2, nachdem ein zweiter Teil der leitenden Struktur, obere Source/Drain-Gebiete von Transistoren und untere Source/Drain-Gebiete der Transistoren erzeugt wurden und die Nitridschicht entfernt wurde.
- Figur 4: zeigt den Querschnitt aus Figur 3, nachdem eine Isolation, Wortleitungen, eine Diffusionsbarriere, und eine weitere Isolation erzeugt wurden.
- Figur 5: zeigt einen Querschnitt durch ein zweites Substrat, nachdem eine erste Oxidschicht, Vertiefungen, eine isolierende Struktur, leitende Strukturen, untere Source/Drain-Gebiete von Transistoren, obere Source/Drain-Gebiete der Transistoren, eine Isolation, eine weitere Isolation und Wortleitungen erzeugt wurden.

Die Figuren sind nicht maßstabsgetreu.

In einem ersten Ausführungsbeispiel ist ein erstes Substrat 1 aus monokristallinem Silizium vorgesehen.

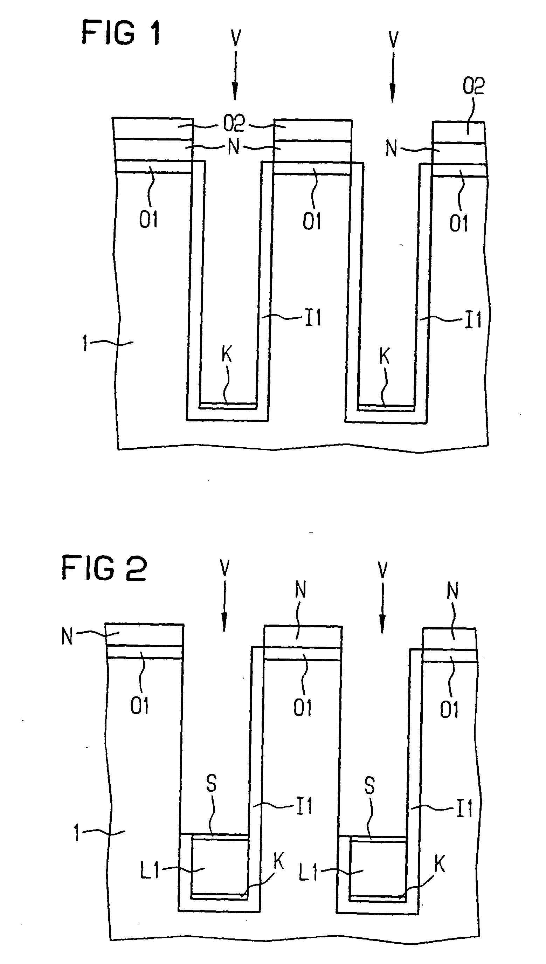

Zur Erzeugung einer Maske wird eine erste Oxidschicht Ol erzeugt, indem SiO₂ in einer Dicke von ca. 20nm durch thermische Oxidation erzeugt wird. Darüber wird Siliziumnitrid in einer Dicke von ca. 50nm abgeschieden, so daß eine Nitridschicht N erzeugt wird. Zur Erzeugung einer zweiten Oxidschicht 02 wird SiO₂ in einer Dicke von ca. 200nm abgeschieden (siehe Figur 1).

Mit Hilfe einer ersten streifenförmigen Photolackmaske (nicht dargestellt), deren Streifen ca. 100nm breit sind_und einen Abstand von ca. 100 nm voneinander aufweisen, werden die zweite Oxidschicht 02, die Nitridschicht N und die erste Oxidschicht 01 strukturiert, so daß das Substrat 1 teilweise freigelegt wird (siehe Figur 1).

Anschließend wird das Substrat 1 mit z.B. HBr ca. 500 nm tief geätzt, so daß Vertiefungen V erzeugt werden, die streifenförmige horizontale Querschnitte aufweisen. Die strukturierte zweite Oxidschicht 02, die Nitridschicht N und die erste Oxidschicht 01 wirken dabei als Maske.

Zur Erzeugung einer ca. 10 nm dicken isolierenden Struktur Il wird eine thermische Oxidation durchgeführt (siehe Figur 1). Die isolierende Struktur 11 bedeckt Flanken und Böden der Vertiefungen V.

Anschließend wird eine Implantation von Silizium bei einer Energie von ca. 5keV und einer Dosis von ca. 5*10¹⁵ cm⁻² durchgeführt, so daß an Böden der Vertiefungen V nach einem Temperschritt bei ca. 800°C eine ca. 2nm dicke Keimschicht K erzeugt wird (siehe Figur 1).

In einem CVD-Verfahren wird Wolfram selektiv auf der Keimschicht K aufgewachsen, so daß in unteren Teilen der Vertiefungen V erste Teile L1 von leitenden Strukturen erzeugt werden (siehe Figur 2). Die ersten Teile L1 der leitenden Strukturen sind ca. 100nm dick.

Anschließend wird eine Implantation von Stickstoff bei einer Energie von ca. 10keV und einer Dosis von 5*10¹⁵ cm⁻² durchgeführt, so daß auf den ersten Teilen L1 der leitenden Strukturen eine Schicht S, die Stickstoff enthält, erzeugt wird.

Durch chemisch-mechanisches Polieren wird die zweite Oxidschicht 02 entfernt.

Mit Hilfe einer streifenförmigen zweiten Photolackmaske (nicht dargestellt), deren Streifen erste Flanken der Vertiefungen V bedecken, werden Teile der isolierenden Struktur I1 mit zum Beispiel HF entfernt, die oberhalb der ersten Teile der leitenden Strukturen L1 an zweiten, den ersten Flanken gegenüberliegenden Flanken der Vertiefungen V angeordnet sind (siehe Figur 2). Anschließend wird die zweite Photolackmaske entfernt.

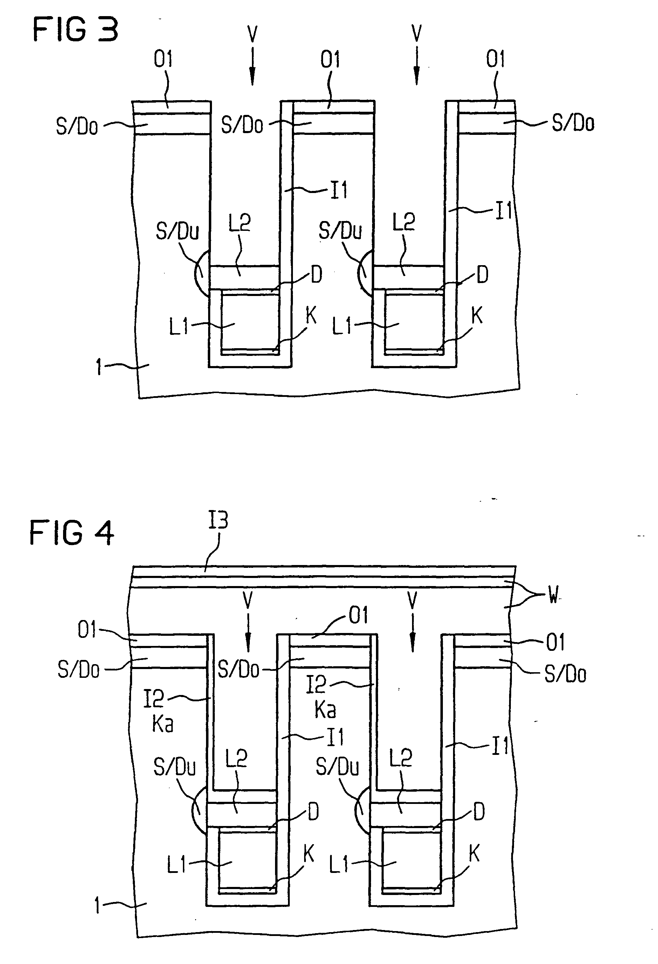

Zur Erzeugung von zweiten Teilen L2 der leitenden Strukturen wird in situ dotiertes Polysilizium in einer Dicke von ca. 50nm abgeschieden, so daß die Vertiefungen V gefüllt werden. Anschließend wird das Polysilizium durch chemisch mechanisches Polieren planarisiert, bis die Nitridschicht N freigelegt wird. Durch Implantation mit n-dotierenden Ionen werden obere Source/Drain-Gebiete S/Do von Transistoren erzeugt, die zwischen zueinander benachbarten Vertiefungen V angeordnet sind (siehe Figur 3). Danach wird das Polysilizium rückgeätzt, so daß die ca. 20nm dicken zweiten Teile der leitenden Strukturen L2 in höheren Teilen der Vertiefungen V erzeugt werden (siehe Figur 3).

Zur Entfernung von Ätzrückständen an den Flanken der Vertiefungen V wird ein ca. 3nm dickes thermisches Oxid (nicht dargestellt) erzeugt und anschließend wieder entfernt. Dabei diffundiert Dotierstoff aus den zweiten Teilen L2 der leitenden Strukturen in das Substrat 1 und bildet dort untere Source/Drain-Gebiete S/Du der Transistoren (siehe Figur 3). Die hohe Temperatur bei der thermischen Oxidation bewirkt darüber hinaus, daß aus der Schicht S, die Stickstoff enthält, aus Wolfram der ersten Teile der leitenden Strukturen L1 und aus Silizium der zweiten Teile der leitenden Strukturen L2 aufgrund von begrenzter Interdiffusion Diffusionsbarrieren D erzeugt werden (siehe Figur 3).

Mit Hilfe von Phosphorsäure wird die Nitridschicht N entfernt (siehe Figur 3). Anschließend wird eine Implantation mit Sauerstoff durchgeführt, so daß die erste Oxidschicht O1 und obere Teile der zweiten Teile L2 der leitenden Strukturen mit Sauerstoff dotiert werden.

Zur Erzeugung einer Isolation I2 wird eine thermische Oxidation durchgeführt. Aufgrund der Sauerstoffimplantation wächst die Isolation I2 auf den zweiten Teilen L2 der leitenden Strukturen dicker auf als auf den zweiten Flanken der Vertiefungen V. An den zweiten Flanken der Vertiefungen V beträgt die Dicke der Isolation I2 ca. 5nm (siehe Figur 4).

Zur Erzeugung von Wortleitungen W wird in situ dotiertes Polysilizium in einer Dicke von ca. 50 nm abgeschieden, so daß die Vertiefungen V gefüllt werden (siehe Figur 4). Darüber wird Wolframsilizid in einer Dicke von ca. 80nm abgeschieden. Zur Erzeugung einer weiteren Isolation I3 wird Siliziumnitrid in einer Dicke von ca. 50nm abgeschieden.

Mit Hilfe einer streifenförmigen dritten Photolackmaske (nicht dargestellt), deren Streifen quer zu den Streifen der ersten Photolackmaske verlaufen, ca. 100nm breit sind und einen Abstand von ca. 100nm voneinander aufweisen, wird Siliziumnitrid, Wolframsilizid und Polysilizium selektiv zu SiO₂ geätzt, bis auf den zweiten Teilen L2 der leitenden Strukturen angeordnete Teile der Isolation I2 freigelegt werden. Aus dem Wolframsilizid und dem Polysilizium werden dadurch die Wortleitungen W erzeugt.

Anschließend wird SiO₂ abgeschieden und rückgeätzt, bis das Substrat 1 freigelegt wird.

Zur Trennung der oberen Source/Drain-Gebiete S/Do bzw. der unteren Source/Drain-Gebiete S/Du von entlang einer der leitenden Strukturen zueinander benachbarten Transistoren, wird das Substrat 1 geätzt, so daß zwischen den Wortleitungen W und zwischen den Vertiefungen V weitere Vertiefungen (nicht dargestellt) erzeugt werden, die einen quadratischen horizontalen Querschnitt aufweisen und tiefer als die höheren Teile der Vertiefungen V reichen. Die oberen Source/Drain-Gebiete S/Do sind folglich unter den Wortleitungen W angeordnet.

Teile der Wortleitungen W, die in den Vertiefungen V über den zweiten Teilen L2 der leitenden Strukturen angeordnet sind, wirken als Gateelektroden der Transistoren. An den zweiten Flanken der Vertiefungen V angeordnete Teile der Isolation I2 wirken als Gatedielektrikum der Transistoren. Teile des Substrats 1, die zwischen den unteren Source/Drain-Gebieten S/Du und den oberen Source/Drain-Gebieten S/Do angeordnet sind, wirken als Kanalgebiete Ka der Transistoren. Die leitenden Strukturen wirken als Bitleitungen. Die leitenden Strukturen sind im Substrat 1 vergraben und sind mit Gebieten des Substrats 1, nämlich mit den unteren Source/Drain-Gebieten S/Du, verbunden.

Anschließend werden Speicherkondensatoren (nicht dargestellt) erzeugt, die jeweils mit einem oberen Source/Drain-Gebiet S/Do der Transistoren verbunden werden. Eine Speicherzelle der durch das beschriebene Verfahren erzeugten DRAM-Zellenanordnung umfaßt einen der Transistoren und einen der mit dem Transistor verbundenen Kondensatoren.

In einem zweiten Ausführungsbeispiel ist ein zweites Substrat 2 aus monokristallinem Silizium vorgesehen. Ca. 1µm unter einer Oberfläche des Substrats 2 ist eine ca. 7µm dicke n-dotierte Schicht P' angeordnet.

Wie im ersten Ausführungsbeispiel wird eine Maske aus einer ersten Oxidschicht 01' an eine Nitridschicht und einer zweiten Oxidschicht erzeugt. Anschließend werden Vertiefungen V' erzeugt, die im Gegensatz zum ersten Ausführungsbeispiel einen quadratischen horizontalen Querschnitt mit einer Seitenlänge von ca. 100nm aufweisen und ca. 7µm tief sind. Es wird eine erste isolierende Struktur 11' erzeugt, die im Gegensatz zum ersten Ausführungsbeispiel aus Stickstoffoxid besteht und ca. 7nm dick ist.

Wie im ersten Ausführungsbeispiel werden eine Keimschicht K', erste Teile L1' von leitenden Strukturen erzeugt, Stickstoff implantiert und Teile der isolierenden Strukturen 11' entfernt.

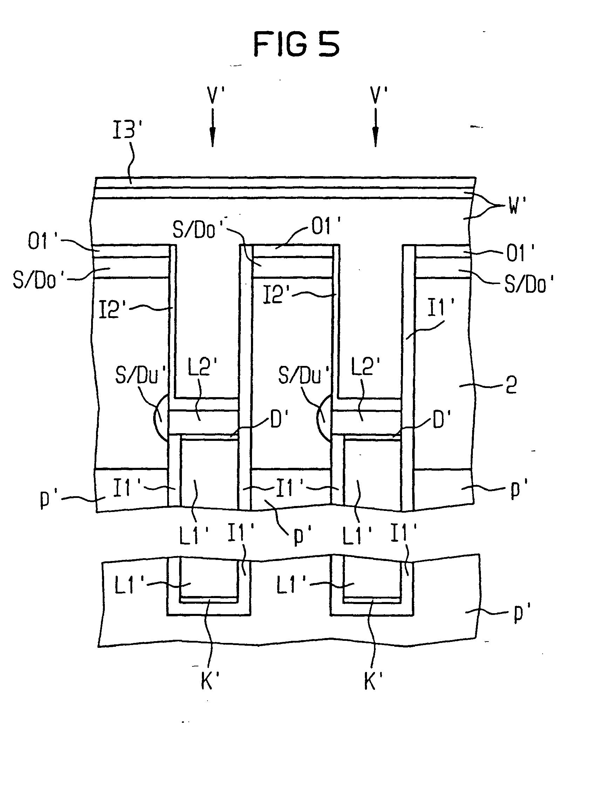

Wie im ersten Ausführungsbeispiel werden zweite Teile L2' der leitenden Strukturen, Diffusionsbarrieren D', obere Source/Drain-Gebiete S/Do', untere Source/Drain-Gebiete S/Du', eine Isolation I2', Wortleitungen W' und eine weitere Isolation 13' erzeugt (siehe Figur 5).

Die leitenden Strukturen wirken als Speicherknoten von Speicherkondensatoren. Die isolierende Struktur I1' wirkt als Kondensatordielektrikum der Speicherkondensatoren. Die dotierte Schicht P' des Substrats 2 wirkt als gemeinsame Kondensatorplatte der Speicherkondensatoren.

Anschließend werden Bitleitungen (nicht dargestellt) erzeugt, die quer zu den Wortleitungen W' verlaufen und über Kontakte mit den oberen Source/Drain-Gebieten S/Do' verbunden werden.

Es sind viele Variationen der Ausführungsbeispiele denkbar, die ebenfalls im Rahmen der Erfindung liegen. Insbesondere können die Abmessungen der beschriebenen Schichten, Masken und Vertiefungen an die jeweiligen Erfordernisse angepaßt werden. Die ersten Teile der leitenden Strukturen können aus anderen Metallen, wie z. B. Molybdän oder Tantal, erzeugt werden.

Die weiteren Vertiefungen können alternativ so flach sein, daß sie lediglich die oberen Source/Drain-Gebiete voneinander trennen, ohne die unteren Source/Drain-Gebiete voneinander zu trennen. In diesem Fall reichen also die weiteren Vertiefungen nicht tiefer als die höheren Teile der Vertiefungen.

## Patentansprüche

1. Substrat mit integrierter Schaltungsanordnung, die eine in dem Substrat vergrabene leitende Struktur umfaßt, die mit einem Gebiet des Substrats elektrisch verbunden ist,
- bei der das Substrat (1) eine Vertiefung (V) aufweist,
- bei der ein Boden und Flanken eines unteren Teils der Vertiefung (V) mit einer isolierenden Struktur (I1) versehen sind,
- bei der ein erster Teil der leitenden Struktur (L1) eine erste elektrische Leitfähigkeit aufweist und im unteren Teil der Vertiefung (V) angeordnet ist,
- bei der ein zweiter Teil der leitenden Struktur (L2) eine zweite elektrische Leitfähigkeit aufweist, die kleiner als die erste elektrische Leitfähigkeit ist, in einem höheren Teil der Vertiefung (V) angeordnet ist und bei einem Teil mindestens einer der Flanken der Vertiefung (V) an das Gebiet des Substrats (1) angrenzt,
- bei der die leitende Struktur eine Diffusionsbarriere (D) aufweist, die zwischen dem ersten Teil (L1) und dem zweiten Teil (L2) der leitenden Struktur angeordnet ist.

2. Substrat mit integrierter Schaltungsanordnung nach Anspruch 1,
- bei der der erste Teil der leitenden Struktur (L1) ein Metall enthält,
- bei der der zweite Teil der leitenden Struktur (L2) Polysilizium enthält,
- bei der die Diffusionsbarriere (D) Stickstoff enthält.

3. Substrat mit integrierter Schaltungsanordnung nach Anspruch 2,
- bei dem das Substrat (1) Silizium enthält,
- bei dem das Polysilizium des zweiten Teils der leitenden Struktur (L2) dotiert ist,
- bei dem das Gebiet des Substrats (1), an das der zweite Teil der leitenden Struktur (L2) angrenzt, dotiert ist.

4. Substrat mit integrierter Schaltungsanordnung nach Anspruch 2 oder 3,
- bei der das Metall Wolfram ist,
- bei der die Diffusionsbarriere (D) Wolfram, Silizium und Stickstoff enthält.

5. Substrat mit integrierter Schaltungsanordnung nach Anspruch 3 oder 4,
- die eine DRAM-Zellenanordnung mit Speicherzellen ist, die jeweils mindestens einen Transistor aufweisen,
- bei der die leitende Struktur eine Bitleitung ist,
- bei der das Gebiet des Substrats (1), an das der zweite Teil der leitenden Struktur (L2) angrenzt, ein Source/Drain-Gebiet (S/Du) des Transistors ist.

6. Substrat mit integrierter Schaltungsanordnung nach Anspruch 3 oder 4,
- die eine DRAM-Zellenanordnung mit Speicherzellen ist, die jeweils mindestens einen Transistor und einen Kondensator aufweisen,
- bei der die leitende Struktur ein Speicherknoten des Kondensators ist,
- bei der die isolierende Struktur (I1') so ausgestaltet ist, daß sie als Kondensatordielektrikum des Kondensators wirken kann,
- bei der das Gebiet des Substrats (2), an das der zweite Teil der leitenden Struktur (L2')angrenzt, ein Source/Drain-Gebiet (S/Du') des Transistors ist.

7. Substrat mit integrierter Schaltungsanordnung nach Anspruch 5 oder 6,
- bei der eine Isolation (I2) die leitende Struktur und oberhalb der leitenden Struktur angeordnete Teile der Flanken der Vertiefung (V) bedeckt,
- bei der eine Gateelektrode des Transistors in der Vertiefung (V) angeordnet ist und durch die Isolation (I2) von der leitenden Struktur und dem Substrat (1) getrennt ist,
- bei der ein weiteres Source/Drain-Gebiet (S/Do) des Transistors oberhalb des Source/Drain-Gebiets (S/Du) angeordnet ist und an die Flanke der Vertiefung (V) angrenzt.

8. Verfahren zur Herstellung einer integrierten Schaltungsanordnung, die eine in einem Substrat vergrabene leitende Struktur umfaßt, die mit einem Gebiet des Substrats elektrisch verbunden ist,
- bei dem im Substrat (1) eine Vertiefung (V) erzeugt wird,
- bei dem ein Boden und Flanken eines unteren Teils der Vertiefung (V) mit einer isolierenden Struktur (I1) versehen werden,
- bei dem ein erster Teil der leitenden Struktur (L1), der eine erste elektrische Leitfähigkeit aufweist, so erzeugt wird, daß er im unteren Teil der Vertiefung (V) angeordnet ist,
- bei dem ein Material auf dem ersten Teil der leitenden Struktur (L1) aufgebracht wird,
- bei dem ein zweiter Teil der leitenden Struktur (L2), der eine zweite elektrische Leitfähigkeit aufweist, die kleiner als die erste elektrische Leitfähigkeit ist, auf dem Material so erzeugt wird, daß er in einem höheren Teil der Vertiefung (V) angeordnet ist und bei einem Teil mindestens einer der Flanken der Vertiefung (V) an das Gebiet des Substrats (1) angrenzt,
- bei dem zwischen dem ersten Teil (L1) und dem zweiten Teil (L2) der leitenden Struktur mit Hilfe des Materials eine Diffusionsbarriere (D) erzeugt wird.

9. Verfahren nach Anspruch 8,
- bei dem der erste Teil der leitenden Struktur (L1) ein Metall enthält,
- bei dem der zweite Teil der leitenden Struktur (L2) erzeugt wird, indem Polysilizium abgeschieden und rückgeätzt wird,
- bei dem die Diffusionsbarriere (D) Stickstoff enthält.

10. Verfahren nach Anspruch 9,
- bei dem nach Erzeugung der isolierenden Struktur (I1) eine Implantation durchgeführt wird, so daß auf einem Teil der isolierenden Struktur (I1), der am Boden der Vertiefung (V) angeordnet ist, eine Keimschicht (K) erzeugt wird,
- bei dem der erste Teil der leitenden Struktur (L1) durch selektives Wachstum auf der Keimschicht (K) erzeugt wird.

11. Verfahren nach Anspruch 9 oder 10,
- bei dem nach Erzeugung des ersten Teils der leitenden Struktur (L1) Stickstoff implantiert wird, und anschließend der zweite Teil der leitenden Struktur (L2) erzeugt wird,
- bei dem ein Temperschritt durchgeführt wird, so daß die Diffusionsbarriere (D) erzeugt wird.

12. Verfahren nach einem der Ansprüche 9 bis 11,
- bei dem das Substrat (1) Silizium enthält,
- bei dem das Polysilizium des zweiten Teils der leitenden Struktur (L2) dotiert ist,
- bei dem aufgrund eines Temperschritts Dotierstoff des zweiten Teils der leitenden Struktur (L2) in das Substrat (1) diffundiert und **dadurch** das Gebiet des Substrats (1), an das der zweite Teil der leitenden Struktur (L2) angrenzt, dotiert wird.

13. Verfahren nach Anspruch 9 bis 12,
- bei dem das Metall Wolfram ist.

14. Verfahren nach Anspruch 12 oder 13,
- bei dem als die integrierte Schaltungsanordnung eine DRAM-Zellenanordnung mit Speicherzellen erzeugt wird,
- bei dem für die Speicherzellen jeweils mindestens ein Transistor erzeugt wird,
- bei dem das Gebiet des Substrats (1), an das der zweite Teil der leitenden Struktur (L2) angrenzt, als ein Source/Drain-Gebiet (S/Do) des Transistors erzeugt wird,
- bei dem die leitende Struktur als eine Bitleitung erzeugt wird.

15. Verfahren nach Anspruch 12 oder 13,
- bei dem als die integrierte Schaltungsanordnung eine DRAM-Zellenanordnung mit Speicherzellen erzeugt wird,
- bei dem für die Speicherzellen jeweils mindestens ein Transistor und ein Kondensator erzeugt werden,
- bei dem das Gebiet des Substrats (2), an das der zweite Teil der leitenden Struktur (L2') angrenzt, als ein Source/Drain-Gebiet (S/Du') des Transistors erzeugt wird,
- bei dem die leitende Struktur als ein Speicherknoten des Kondensators erzeugt wird,
- bei dem die isolierende Struktur (I1') so erzeugt wird, daß sie als Kondensatordielektrikum des Kondensators wirken kann.

16. Verfahren nach Anspruch 14 oder 15,
- bei dem nach Erzeugung des zweiten Teils der leitenden Struktur (L2) eine thermische Oxidation durchgeführt wird, so daß eine Isolation (I2) die leitende Struktur und oberhalb der leitenden Struktur angeordnete Teile der Flanken der Vertiefung (V) bedeckt,
- bei dem nach Erzeugung der Isolation (I2) eine Gateelektrode des Transistors in der Vertiefung (V) erzeugt wird, die durch die Isolation (I2) von der leitenden Struktur und vom Substrat (1) getrennt ist,
- bei dem ein weiteres Source/Drain-Gebiet (S/Do) des Transistors oberhalb des Source/Drain-Gebiets (S/Du) so erzeugt wird, daß sie an die Flanke der Vertiefung (V) angrenzt.

## Claims

1. Substrate with integrated circuit arrangement comprising a conductive structure which is buried in the substrate and is electrically connected to a region of the substrate,
- in which the substrate (1) has a depression (V),
- in which a bottom and sidewalls of a lower part of the depression (V) are provided with an insulating structure (I1),
- in which a first part of the conductive structure (L1) has a first electrical conductivity and is arranged in the lower part of the depression (V),
- in which a second part of the conductive structure (L2) has a second electrical conductivity, which is lower than the first electrical conductivity, is arranged in a higher part of the depression (V) and adjoins the region of the substrate (1) at a part of at least one of the sidewalls of the depression (V),
- in which the conductive structure has a diffusion barrier (D) arranged between the first part (L1) and the second part (L2) of the conductive structure.

2. Substrate with integrated circuit arrangement according to claim 1,
- in which the first part of the conductive structure (L1) contains a metal,
- in which the second part of the conductive structure (L2) contains polysilicon,
- in which the diffusion barrier (D) contains nitrogen.

3. Substrate with integrated circuit arrangement according to claim 2,
- in which the substrate (1) contains silicon,
- in which the polysilicon of the second part of the conductive structure (L2) is doped,
- in which the region of the substrate (1) adjoined by the second part of the conductive structure (L2) is doped.

4. Substrate with integrated circuit arrangement according to claim 2 or 3,
- in which the metal is tungsten,
- in which the diffusion barrier (D) contains tungsten, silicon and nitrogen.

5. Substrate with integrated circuit arrangement according to claim 3 or 4,
- which is a DRAM cell arrangement having memory cells each having at least one transistor,
- in which the conductive structure is a bit line,
- in which the region of the substrate (1) adjoined by the second part of the conductive structure (L2) is a source/drain region (S/Du) of the transistor.

6. Substrate with integrated circuit arrangement according to claim 3 or 4,
- which is a DRAM cell arrangement having memory cells which each have at least one transistor and a capacitor,
- in which the conductive structure is a storage node of the capacitor,
- in which the insulating structure (I1') is configured in such a way that it can act as a capacitor dielectric of the capacitor,
- in which the region of the substrate (2) adjoined by the second part of the conductive structure (L2') is a source/drain region (S/Du') of the transistor.

7. Substrate with integrated circuit arrangement according to claim 5 or 6,
- in which an insulation (I2) covers the conductive structure and parts of the sidewalls of the depression (V) which are arranged above the conductive structure,
- in which a gate electrode of the transistor is arranged in the depression (V) and is isolated from the conductive structure and the substrate (1) by the insulation (I2),
- in which a further source/drain region (S/Do) of the transistor is arranged above the source/drain region (S/Du) and adjoins the sidewall of the depression (V).

8. Method for fabricating an integrated circuit arrangement comprising a conductive structure which is buried in a substrate and is electrically connected to a region of the substrate,
- in which a depression (V) is produced in the substrate (1),
- in which a bottom and sidewalls of a lower part of the depression (V) are provided with an insulating structure (I1),
- in which a first part of the conductive structure (L1), which has a first electrical conductivity, is produced in such a way that it is arranged in the lower part of the depression (V),
- in which a material is applied on the first part of the conductive structure (L1),
- in which a second part of the conductive structure (L2), which has a second electrical conductivity, which is lower than the first electrical conductivity, is produced on the material in such a way that it is arranged in a higher part of the depression (V) and adjoins the region of the substrate (1) at a part of at least one of the sidewalls of the depression (V),
- in which a diffusion barrier (D) is produced between the first part (L1) and the second part (L2) of the conductive structure with the aid of the material.

9. Method according to claim 8,
- in which the first part of the conductive structure (L1) contains a metal,
- in which the second part of the conductive structure (L2) is produced by depositing polysilicon and etching it back,
- in which the diffusion barrier (D) contains nitrogen.

10. Method according to claim 9,
- in which an implantation is carried out after the production of the insulating structure (I1), with the result that a seed layer (K) is produced on a part of the insulating structure (I1) which is arranged at the bottom of the depression (V),
- in which the first part of the conductive structure (L1) is produced by selective growth on the seed layer (K).

11. Method according to claim 9 or 10,
- in which, after the production of the first part of the conductive structure (L1), nitrogen is implanted, and the second part of the conductive structure (L2) is subsequently produced,
- in which a heat treatment step is carried out to produce the diffusion barrier (D).

12. Mmethod according to one of claims 9 to 11,
- in which the substrate (1) contains silicon,
- in which the polysilicon of the second part of the conductive structure (L2) is doped,
- in which, on account of a heat treatment step, dopant of the second part of the conductive structure (L2) diffuses into the substrate (1) and, as a result, the region of the substrate (1) adjoined by the second part of the conductive structure (L2) is doped.

13. Method according to claims 9 to 12,
- in which the metal is tungsten.

14. Method according to claim 12 or 13,
- in which a DRAM cell arrangement having memory cells is produced as the integrated circuit arrangement,
- in which at least one transistor is produced for each of the memory cells,
- in which the region of the substrate (1) adjoined by the second part of the conductive structure (L2) is produced as a source/drain region (S/Do) of the transistor,
- in which the conductive structure is produced as a bit line.

15. Method according to claim 12 or 13,
- in which a DRAM cell arrangement having memory cells is produced as the integrated circuit arrangement,
- in which at least one transistor and a capacitor are produced for each of the memory cells,
- in which the region of the substrate (2) adjoined by the second part of the conductive structure (L2') is produced as a source/drain region (S/Du') of the transistor,
- in which the conductive structure is produced as a storage node of the capacitor,
- in which the insulating structure (I1') is produced in such a way that it can act as a capacitor dielectric of the capacitor.

16. Method according to claim 14 or 15,
- in which a thermal oxidation is carried out after the production of the second part of the conductive structure (L2), with the result that an insulation (I2) covers the conductive structure and parts of the sidewalls of the depression (V) which are arranged above the conductive structure,
in which, after the production of the insulation (I2), a gate electrode of the transistor is produced in the depression (V), which is isolated from the conductive structure and from the substrate (1) by the insulation (I2),
- in which a further source/drain region (S/Do) of the transistor is produced above the source/drain region (S/Du) in such a way that it adjoins the sidewall of the depression (V).

## Revendications

1. Substrat ayant un circuit intégré, qui comprend une structure conductrice enterrée dans le substrat et reliée électriquement à une zone du substrat,
- dans lequel le substrat (1) a une cavité (V) ;
- dans lequel un fond et des flancs d'une partie inférieure de la cavité (V) sont munis d'une structure (I1) isolante ;
- dans lequel une première partie (L1) de la structure conductrice a une première conductivité électrique et est disposée dans la partie inférieure de la cavité (V) ;
- dans lequel une deuxième partie (L2) de la structure conductrice a une deuxième conductivité électrique qui est plus petite que la première conductivité électrique et est disposée dans une partie plus haute de la cavité (V) et pour une partie d'au moins l'un des flancs de la cavité (V) est voisine de la zone du substrat (1) ;
- dans lequel la structure conductrice a une barrière (D) de diffusion, qui est disposée entre la première partie (L1) et la deuxième partie (L2) de la structure conductrice.

2. Substrat ayant un circuit intégré suivant la revendication 1,
- dans lequel la première partie (L1) de la structure conductrice contient un métal ;
- dans lequel la deuxième partie (L2) de la structure conductrice contient du polysilicium ;
- dans lequel la barrière (D) de diffusion contient de l'azote.

3. Substrat ayant un circuit intégré suivant la revendication 2,
- dans lequel le substrat (1) contient du silicium ;
- dans lequel le polysilicium de la deuxième partie (L2) de la structure conductrice est dopé ;
- dans lequel la zone du substrat (1) dont la deuxième partie (L2) de la structure conductrice est voisine est dopée.

4. Substrat ayant un circuit intégré suivant la revendication 2 ou 3,
- dans lequel le métal est du tungstène;
- dans lequel la barrière (D) de diffusion contient du tungstène, du silicium et de l'azote.

5. Substrat ayant un circuit intégré suivant la revendication 3 ou 4,
- qui est un agencement de cellules DRAM ayant des cellules de mémoire qui ont, respectivement, au moins un transistor ;
- dans lequel la structure conductrice est une ligne de bit ;
- dans lequel la zone du substrat (1) dont la deuxième partie (L2) de la structure conductrice est voisine est une zone (S/Du) de source/drain du transistor.

6. Substrat ayant un circuit intégré suivant la revendication 3 ou 4,
- qui est un agencement de cellules DRAM ayant des cellules de mémoire qui ont, respectivement, au moins un transistor et un condensateur ;
- dans lequel la structure conductrice est un noeud de mémoire du condensateur ;
- dans lequel la structure (I1') isolante est telle qu'elle peut agir en tant que diélectrique du condensateur ;
- la zone du substrat (2) dont la deuxième partie (L2') de la structure conductrice est voisine est une zone (S/Du') de source/drain du transistor.

7. Substrat ayant un circuit intégré suivant la revendication 5 ou 6,
- dans lequel un isolant (I2) recouvre la structure conductrice et des parties des flancs de la cavité (V), qui sont disposés au-dessus de la structure conductrice ;
- dans lequel une électrode de grille du transistor est disposée dans la cavité (V) et est séparée par l'isolant (12) de la structure conductrice et du substrat (1) ;
- dans lequel une autre zone (S/Do) de source/drain du transistor est disposée au-dessus de la zone (S/Du) de source/drain et est voisine des flancs de la cavité (V).

8. Procédé de production d'un circuit intégré qui comprend une structure conductrice enterrée dans un substrat et reliée électriquement à une zone du substrat,
- dans lequel on produit une cavité (V) dans le substrat (1) ;
- dans lequel on munit un fond et des flancs d'une partie inférieure de la cavité (V) d'une structure (I1) isolante ;
- dans lequel on produit une première partie (L1) de la structure conductrice qui a une première conductivité électrique de façon à ce qu'elle soit disposée dans la partie inférieure de la cavité (V) ;
- dans lequel on dépose un matériau sur la première partie (L1) de la structure conductrice
- dans lequel on produit une deuxième partie (L2) de la structure conductrice qui a une deuxième conductivité électrique plus petite que la première conductivité électrique sur le matériau de manière à ce qu'elle soit disposée dans une partie plus haute de la cavité (V) et à ce qu'une partie d'au moins l'un des flancs de la cavité (V) soit voisine de la zone du substrat (1);
- dans lequel on produit entre la première partie (L1) et la deuxième partie (L2) de la structure conductrice une barrière (D) de diffusion à l'aide du matériau.

9. Procédé suivant la revendication 8,
- dans lequel la première partie (L1) de la structure conductrice contient un métal ;
- dans lequel on produit la deuxième partie (L2) de la structure conductrice en déposant du polysilicium et en l'attaquant latéralement ;
- dans lequel la barrière (D) de diffusion contient de l'azote.

10. Procédé suivant la revendication 9,
- dans lequel on effectue après la production de la structure (I1) isolante une implantation de façon à produire sur une partie de la structure (I1) isolante qui est déposée au fond de la cavité (V) une couche (K) de germe ;
- dans lequel on produit la première partie (L1) de la structure conductrice par croissance sélective sur la couche (K) de germe.

11. Procédé suivant la revendication 9 ou 10,
- dans lequel on implante après la production de la première partie (L1) de la structure conductrice de l'azote et on produit ensuite la deuxième partie (L2) de la structure conductrice ;
- dans lequel on effectue un stade de recuit de manière à produire la barrière (D) de diffusion.

12. Procédé suivant l'une des revendications 9 à 11,
- dans lequel le substrat (1) contient du silicium ;
- dans lequel le polysilicium de la deuxième partie (L2) de la structure conductrice est dopé ;
- dans lequel, en raison d'un stade de recuit, de la substance de dopage de la deuxième partie (L2) de la structure conductrice diffuse dans le substrat (1) et dope ainsi la zone du substrat (1) dont la deuxième partie (L2) de la structure conductrice est voisine.

13. Procédé suivant l'une des revendications 9 à 12,
- dans lequel le métal est du tungstène.

14. Procédé suivant la revendication 12 ou 13,
- dans lequel on produit en tant que circuit intégré un agencement de cellules DRAM ayant des cellules de mémoire ;
- dans lequel on produit pour les cellules de mémoire, respectivement, au moins un transistor ;
- dans lequel on produit la zone du substrat (1) dont la deuxième partie (L2) de la structure conductrice est voisine en tant que zone (S/Do) de source/drain du transistor ;
- dans lequel on produit la structure conductrice en tant qu'une ligne de bit.

15. Procédé suivant la revendication 12 ou 13,
- dans lequel on produit comme circuit intégré un agencement de cellules DRAM ayant des cellules de mémoire ;
- dans lequel on produit pour les cellules de mémoire respectivement au moins un transistor et un condensateur ;
- dans lequel on produit la zone du substrat (2) dont la deuxième partie (L2') de la structure conductrice est voisine en tant que zone (S/Du') de source/drain du transistor ;
- dans lequel on produit la structure conductrice en tant que noeud de mémoire du condensateur ;
- dans lequel on produit la structure (I1') isolante de façon à ce qu'elle puisse servir de diélectrique du condensateur.

16. Substrat ayant un circuit intégré suivant la revendication 14 ou 15,
- dans lequel on effectue une oxydation thermique après la production de la deuxième partie (L2) de la structure conductrice de façon à ce qu'un isolant (I2) recouvre la structure conductrice et des parties des flancs de la cavité (V), qui sont disposées au-dessus de la structure conductrice ;
- dans lequel on produit après la production de l'isolant (I2) une électrode de grille du transistor dans la cavité (V) qui est séparée par l'isolant (I2) de la structure conductrice et du substrat (1) ;
- dans lequel on produit une autre zone (S/Do) de source/drain du transistor au-dessus de la zone (S/Du) de source/drain de façon à ce qu'elle soit voisine des flancs de la cavité (V).
